(19) **Europäisches Patentamt / European Patent Office / Office européen des brevets**

(11) **EP 1 547 289 B1**

(12) **FASCICULE DE BREVET EUROPEEN**

(45) Date de publication et mention
de la délivrance du brevet:
**29.04.2009 Bulletin 2009/18**

(21) Numéro de dépôt: **03775459.5**

(22) Date de dépôt: **01.10.2003**

(51) Int Cl.:
***H04L 1/00*** *(2006.01)*

(86) Numéro de dépôt international:
**PCT/FR2003/002878**

(87) Numéro de publication internationale:
**WO 2004/032397 (15.04.2004 Gazette 2004/16)**

(54) **RECEPTION D'UN SIGNAL MODULE SELON UNE TECHNIQUE DE CODAGE MULTI-NIVEAUX**

EMPFANG EINES MEHRPEGELKODIERUNGSTECHNIK-MODULIERTEN SIGNALS

RECEPTION OF A SIGNAL MODULATED ACCORDING TO A MULTILEVEL CODING TECHNIQUE

(84) Etats contractants désignés:
**AT BE BG CH CY CZ DE DK EE ES FI FR GB GR HU IE IT LI LU MC NL PT RO SE SI SK TR**

(30) Priorité: **01.10.2002 FR 0212158**

(43) Date de publication de la demande:
**29.06.2005 Bulletin 2005/26**

(73) Titulaire: **TDF**
**75015 Paris Cedex 15 (FR)**

(72) Inventeurs:
• **JAHAN, Bruno**
**F-35190 Tinteniac (FR)**
• **LOUIN, Pierrick**
**35700 Rennes (FR)**

(74) Mandataire: **Vidon, Patrice et al**
**Cabinet Vidon**
**Technopole Atalante**
**16B Rue de Jouanet**
**BP 90333**
**35703 Rennes Cedex 7 (FR)**

(56) Documents cités:
**EP-A- 0 540 232        WO-A-01/67617**

• **PAPKE L ET AL: "Different iterative decoding algorithms for combined concatenated coding and multiresolution modulation" COMMUNICATIONS, 1994. ICC '94, SUPERCOMM/ICC '94, CONFERENCE RECORD, 'SERVING HUMANITY THROUGH COMMUNICATIONS.' IEEE INTERNATIONAL CONFERENCE ON NEW ORLEANS, LA, USA 1-5 MAY 1994, NEW YORK, NY, USA,IEEE, 1 mai 1994 (1994-05-01), pages 1249-1254, XP010126691 ISBN: 0-7803-1825-0**
• **KHAIRY M M ET AL: "ASYMMETRIC MODULATION AND MULTISTAGE CODING FOR MULTICASTING WITH MULTI-LEVEL RECEPTION OVER FADING CHANNELS" MILCOM 1999. IEEE MILITARY COMMUNICATIONS CONFERENCE PROCEEDINGS. ATLANTIC CITY, NJ, OCT. 31 - NOV. 3, 1999, IEEE MILITARY COMMUNICATIONS CONFERENCE, NEW YORK, NY: IEEE, US, vol. VOL 1 OF 2 CONF. 18, 31 octobre 1999 (1999-10-31), pages 92-96, XP000921925 ISBN: 0-7803-5539-3**
• **KUEHN V: "EVALUATING THE PERFORMANCE OF TURBO CODES AND TURBO-CODED MODULATION IN A DS-CDMA ENVIRONMENT" IEEE JOURNAL ON SELECTED AREAS IN COMMUNICATIONS, IEEE INC. NEW YORK, US, vol. 17, no. 12, décembre 1999 (1999-12), pages 2138-2147, XP000920309 ISSN: 0733-8716**
• **MARTIN P A ET AL: "ON MULTILEVEL CODES AND ITERATIVE MULTISTAGE DECODING" IEEE TRANSACTIONS ON COMMUNICATIONS, IEEE INC. NEW YORK, US, vol. 49, no. 11, novembre 2001 (2001-11), pages 1916-1925, XP001076549 ISSN: 0090-6778**

**(Cont. page suivante)**

- **BURR A G: "Design of optimum M-PSK codes for Rayleigh fading channel" IEE PROCEEDINGS: COMMUNICATIONS, INSTITUTION OF ELECTRICAL ENGINEERS, GB, vol. 147, no. 1, 11 février 2000 (2000-02-11), pages 13-17, XP006013954 ISSN: 1350-2425**

**Description**

Le domaine de l'invention est celui du traitement du signal et des communications numériques. '

Plus précisément, l'invention concerne une technique d'optimisation du décodage d'un signal modulé selon une technique de codage multi-niveaux, ou MLC (pour l'anglais "Multi-Level Coding").

On connaît à ce jour plusieurs techniques de codage de canal à modulations codées. En effet, à la suite de la découverte par Ungerboeck des - modulations codées en treillis, encore appelées MCT ("Channel Coding with Multilevel/ phase Signals", en français "Codage de canal avec des signaux multiniveaux/phases", IEEE Trans. IT, Janvier 1982, 28, n°1, pp. 55-67), les modulations codées en bloc, ou MCB, et les modulations multidimensionnelles codées en treillis ont été proposées.

Les modulations de type MCB ont notamment été décrites par Cusack dans "Error control codes for QAM signalling" (en français "Codes de contrôle d'erreurs pour une signalisation MAQ"), Electronics Letter, janvier 1984, 20, pp. 62-63 et par Sayegh dans "A class of optimum block codes in signal space" (en français "une classe de codes en bloc optimum dans l'espace signal"), IEEE Trans. COM, octobre 1986, 34, n°10, pp. 1043-1045.

Les modulations multidimensionnelles codées en treillis ont notamment été décrites par Wei dans "Treillis-coded Modulation with Multidimensional Constellations" (en français "Modulation codée en treillis avec constellations multidimensionnelles"), IEEE Trans. IT, juillet 1987, 33, n°4, pp. 483-501 et par Calderbank et Sloane dans "New treillis codes based on lattices and cosets" (en français "Nouveaux codes en treillis basés sur les treillis et les groupes conjugués"), IEEE Trans. IT, Mars 1987, 33, n°2, pp. 177-195.

Des modulations codées en treillis de complexité modérée (typiquement à 4 ou 8 états) peuvent donner un gain de codage de 3 à 4 dB. Cependant, dans les applications de faisceaux hertziens à grande capacité, l'implantation du décodeur de Viterbi nécessaire pour décoder ces modulations reste très coûteuse.

Une nouvelle famille de codes MCB a donc été proposée pour ces applications particulières. L'implantation de tels codes est simple, mais leur gain de codage est généralement limité à 2dB.

Une technique de codage attrayante pour ces applications de faisceaux hertziens à grande capacité a été proposée par Imai et Hirakawa dans "A new multilevel coding method using error-correction codes" (en français "une nouvelle méthode de codage multi-niveaux, utilisant des codes correcteurs d'erreurs"), IEEE Trans. IT, mai 1977, 23, n°3, pp. 371-377. Cette technique est celle du codage multi-niveaux, dont l'intérêt réside dans l'existence d'un procédé simple de décodage, s'effectuant par étapes, et présentant un bon compromis entre performances et complexité d'implantation.

On rappelle ci-après brièvement le principe du codage multi-niveaux, ainsi que le procédé de décodage par étapes associé.

On considère une constellation $A_0$ à $2^m$ points, qui est donc capable d'assurer la transmission de $m$ bits par symbole.

Si $m$ désigne le nombre de bits à coder, la constellation $A_0$ est partitionnée en $m$ niveaux, donnant ainsi $2^m$ sous-ensembles. Le principe de cette partition est identique à celui défini par Ungerboeck, et sert à maximiser la distance euclidienne minimale dans les sous-ensembles de la partition. Si on désigne par $d_i$ la distance euclidienne minimale dans les sous-ensembles obtenus au $i^{ème}$ niveau de partition, on doit vérifier l'inégalité suivante :

$$(1) \qquad d_0 < d_1 < d_2 < \ldots < d_m$$

où $d_0$ est la distance minimale dans la constellation $A_0$.

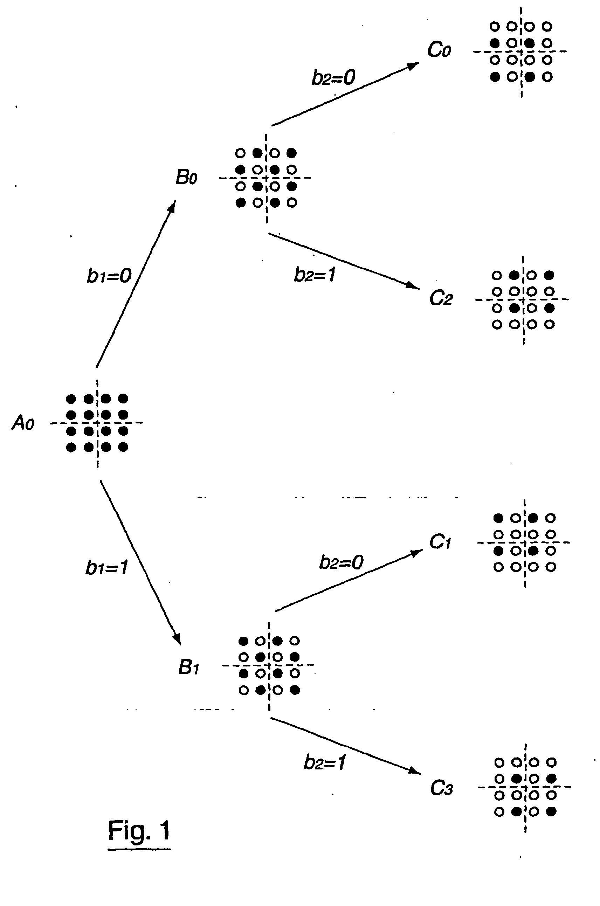

Ainsi, les $m$ bits $b_1$, $b_2$, ..., $b_m$, où $b_i$ est le bit affecté au $i^{ème}$ niveau de la partition, sélectionnent un sous-ensemble parmi les $2^m$. La figure 1 donne le schéma de cette partition dans le cas où $m = 2$. $A_0$ est partitionnée tout d'abord en deux sous-ensembles $B_i$, $i \in \{0, 1\}$ et où $i = b_1$, de distance minimale $d_1$, puis en quatre sous-ensembles $C_i$, $i \in \{0, 1, 2, 3\}$ et où $i = b_1 + 2b_2$, de distance minimale $d_2$. Dans le cas où $A_0$ est une constellation carrée de distance euclidienne $d_0$, $d_1 = \sqrt{2}d_0$ et $d_2 = \sqrt{2}d_1 = 2d_0$.

Ce procédé d'affectation des points de la constellation $A_0$ a pour but de classer les $m$ bits que représente le symbole émis, en fonction de leur vulnérabilité vis-à-vis du bruit. On peut en effet constater que le bit $b_2$ est moins vulnérable que le bit $b_1$, puisqu'il lui correspond une distance euclidienne minimale de $d_2 > d_1$. D'après la relation (1), on peut montrer que si les bits $b_k$, $k \le i-1$ sont suffisamment protégés pour qu'ils soient reçus correctement, le bit $b_i$, $i \le m$ est mieux protégé vis-à-vis du bruit que tous les autres bits $b_j$, $j < i$. On a donc envisagé de coder ces bits séparément avec des codes différents.

C'est le principe du codage multi-niveaux qui consiste, après avoir partitionné la constellation $A_0$ en $m$ niveaux, à utiliser $m$ codeurs $E_i$, $i = 1, ..., m$, pour protéger ces $m$ bits avec plusieurs niveaux de protection.

En d'autres termes, le principe du codage multi-niveaux repose sur l'optimisation conjointe du codage et de la modulation, permettant d'atteindre les meilleures performances de transmission. Ainsi, dans le cadre d'une modulation QAM ("Quadrature_Amplitude Modulation"-pour "modulation d'amplitude en quadrature"), on accorde une plus grande protection aux bits qui, du fait de leur position dans le mappage QAM, sont plus susceptibles d'être entachés d'erreur. La protection accordée aux différents bits est fonction du codage utilisé.

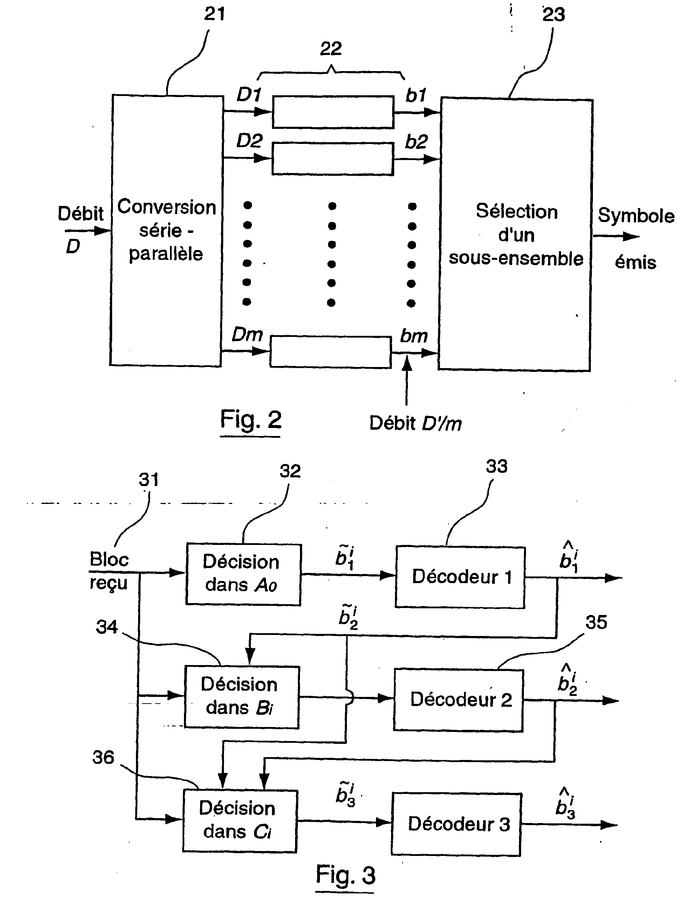

Le schéma de ce concept de codage est illustré par la figure 2. Le train de données à transmettre, de débit $D$, est divisé par le bloc de conversion série-parallèle 21 en $m$ trains de débit $D_i$, $i = 1, ..., m$. Les $m$ premiers trains sont codés par $m$ codes binaires $E_i$ $(n_i, k_i, d_i)$, $i = 1, ..., m$, référencés 22, de taux de codage $R_i = -k_i / n_i$ et de distance de Hamming minimale $d_i$. A l'entrée du modulateur 23, les $m$ trains binaires doivent être synchrones, de débit $D'/m$. On peut donc définir un taux de codage équivalent $R$ donné par :

$$R = D / D'$$

Si l'on suppose que tous les $n_i$ sont égaux, soit $n_i = n$, $i = 1, ...,m$ , et que les $m$ codes $E_i$ sont des codes en bloc, on peut décrire ce codage par une structure matricielle identique à celle utilisée pour les MCB décrites notamment par Sayegh dans l'article cité précédemment. Un mot de code contient $n$ symboles et peut être représenté par une matrice à $m$ lignes et $n$ colonnes où la $j^{ième}$ colonne représente l'affectation binaire du $j^{ième}$ symbole du bloc, et la $i^{ième}$ ligne représente le $i^{ième}$ niveau de partition. La ligne $i$, $i = 1, ..., m$ est un mot de code $E_i$ $(n_i, k_i, d_i)$, La distance euclidienne minimale d obtenue avec ce codage, est donnée par :

$$(3) \qquad d^2 = \min{}_{i=1,...,m+1} (d_i d_{i-1}{}^2), \qquad \text{avec } d_{m+1} = 1.$$

Sachant que les $d_i$ vérifient la relation (1) ci-dessus, le codage multi-niveaux est optimisé si :

$$(4) \qquad d_1 > d_2 > ... > d_m.$$

On a donc déterminé que le bit $b_1$ devrait être le bit le plus protégé, puis $b_2$ etc. Cette description matricielle peut être généralisée au cas où les codes seraient quelconques. Si les $n_i$ ne sont pas identiques, il suffit de considérer une matrice à $m$ lignes et $l$ colonnes où $l$ est le plus petit commun multiple des $n_i$, $i = l, ..., m$. Dans le cas particulier où l'un des codes est un code convolutif, la matrice à considérer est semi-infinie.

Le procédé de décodage classiquement utilisé en association avec un tel codage multi-niveaux est un décodage par étapes sous-optimal, qui présente l'avantage d'être d'implantation très simple.

Selon cette technique, le procédé de décodage s'effectue par étapes où chaque bit est décodé de façon indépendante par un décodeur simple opérant sur des décisions fermes, mais où la sortie du décodeur *(i)* peut apporter une correction sur les bits à l'entrée du décodeur *(i+1)*. La figure 3 donne le schéma bloc de ce type de décodeur, dans le cas où $m = 2$. Etant donné $(r_1, r_2, ..., r_n)$ le bloc 31 de $n$ symboles reçus à l'entrée du décodeur, l'opération de décodage se fait selon les étapes successives suivantes :

- on décode tout d'abord les n bits $b^i_l$, $i=1,...,n$ affectés au premier niveau de partition $(A_0)$ : une décision ferme 32 dans $A_0$ est effectuée sur tous les $r_i$, $i=1,...,n$. On obtient ainsi une première estimation de $b^i_1$, $i=1,...,n$ , notée $\tilde{b}_1{}^i$, $i=l,...,n$. Un décodage à décisions fermes 33 opérant sur $\tilde{b}_1{}^i$, $i=1,...,n$ fournit une estimation finale notée $\tilde{b}_1{}^i$ , $i=1,...,n$.
- ou décode ensuite les n bits $b^i_2$, $i=1,...,n$. affectes au deuxième niveau de partition ($B_0$ ou $B_l$) : en fonction des bits $\tilde{b}_1{}^i$, $i=1,...,n$, qui sont codés par le même codeur utilisé à l'émission, une deuxième opération de décision 34 est effectuée sur les symboles $r_i$ $i=l,...,n$ dans les sous-ensembles $B_{pi}$ avec $p_l = \tilde{b}_1{}^i$ pour $i=1,...,n$. Les bits $\tilde{b}_1{}^i$, $i=l,...,n$ obtenus sont décodés par le décodeur "2" référencé 35 pour donner une décision finale $\tilde{b}_1{}^i$, $i=1,...,n$.
- on décode enfin les bits non codes restants: à partir des bits $\tilde{b}_1{}^i, \tilde{b}_2{}^i$ $i=1,...,n$, recodés par leur codeur associé, on opère une troisième détection 36 de $r_b$ $i=1,...,n$, dans les sous-ensembles de deuxième niveau de partition $C_i$, $i=1,..., n$. On obtient ainsi une estimation des $m-2$ bits non codés restants pour chacun des symboles $r_b$ $i=1,...,n$.

Selon la technique de décodage associée au codage multi-niveaux MLC, le premier décodage s'effectue donc systématiquement dans le sous-ensemble $A_0$ de la constellation. La résultat de ce décodage est ensuite exploité pour le décodage du sous-ensemble suivant $B_0$.

Une telle technique de décodage est notamment décrite dans l'article de L, Papke et K. Fazal intitulé "Different Iterative Decoding Algorithms for Combined Concentrated Coding and Multiresolution Modulation," dans le domaine de la diffusion terrestre de signaux de télévision, codés selon une technique de codage multi-niveaux, Plus précisément, ce document PAPRE décrit une solution à partir du codage et décodage multi-niveaux pour obtenir trois flux liés à trois services différents, le flux SDVT étant plus robuste que le flux EDTV, Lui-même plus robuste que le flux HDTV. Celte technique PAPKE a our objectif de protéger les flux les plus importants, en accentuant la robustesse du niveau auquel ils sont associés. En pratique, selon la technique de décodage de PAPKE, on estima tout d'abord les bits $u_i^1$ affectés à la constellation à $2^m$ points, puis les bits $u_i^2$ affectés aux sous-ensembles de la constellation correspondant à $u_1^1$ etc.

Or, pour qu'un tel décodage MLC soit optimal, le gain de codage qu'il est nécessaire d'obtenir entre les différents niveaux de codage est de 6dB, ce qui est très difficile à obtenir.

Un inconvénient de cette technique de l'art antérieur est donc que le procédé de décodage classiquement mis en oeuvre dans le cadre du codage *MLC* présente des performances médiocres.

Notamment, une telle technique de décodage sous-optimal par étapes est peu adaptée aux canaux présentant un bruit additif gaussien et aux canaux à trajets multiples affectés de Doppler.

L'invention a notamment pour objectif de pallier ces inconvénients de l'art antérieur.

Plus précisément, un objectif de l'invention est de fournir une technique de décodage d'un signal modulé selon une technique de codage MLC, présentant des performances accrues par rapport aux techniques de l'art antérieur.

Un autre objectif de l'invention est de mettre en oeuvre une telle technique, qui permette de réduire le taux d'erreurs binaires (ou TEB) par rapport à la technique de décodage sous-optimal de l'an antérieur.

L'invention a encore pour objectif de fournir une telle technique qui soit simple et peu coûteuse à mettre en oeuvre, et qui soit adaptée aux canaux sujets à perturbations, et notamment aux canaux présentant un bruit additif gaussien et aux canaux à trajets multiples affectés de Doppler.

Ces objectifs, ainsi que d'autres qui apparaîtront par la suite, sont atteints à l'aide d'un procédé de réception d'un signal modulé selon la revendication 1.

Ainsi, l'invention repose sur une approche tout à fait nouvelle et inventive du décodage d'un signal modulé selon une technique de codage multi-niveaux. En effet, contrairement au procédé de décodage sous-optimal utilisé dans l'art antérieur, l'invention propose de réaliser un décodage des différents niveaux de partition qui tienne compte de la vulnérabilité de ces derniers vis-à-vis du bruit. Ainsi, on décode en premier le niveau le plus robuste, afin de pouvoir ensuite propager le résultat du décodage de ce niveau aux niveaux moins robustes. On obtient ainsi des performances de décodage fortement accrues par rapport aux techniques de décodage sous-optimales de l'art antérieur.

Avantageusement, ledit ordre prédéterminé correspond à l'ordre décroissant de la robustesse des niveaux de codage auxquels sont affectés lesdits bits reçus.

Préférentiellement, chacune desdites étapes successives de décodage tient compte du résultat de la ou lesdites étape(s) de décodage précédente(s), de façon à améliorer le résultat desdites étapes de décodage desdits bits affectés aux niveaux moins robustes.

Ainsi, le résultat du décodage des bits d'un niveau de robustesse donné est systématiquement exploité lors du décodage des bits du niveau de robustesse directement inférieur, ce qui permet d'améliorer fortement la confiance que l'on peut accorder à ce deuxième décodage.

Selon une variante avantageuse de l'invention, lesdits bits affectés audit niveau le plus robuste sont les bits les plus significatifs dudit symbole correspondant.

Cette variante de réalisation correspond notamment au mode de mise en oeuvre particulier retenu par le consortium de normalisation DRM (Digital Radio Mondiale, tel que présenté dans le document ETSI ES 201 980 V1.2.1 (2002-07)).

De manière préférentielle, au sein d'une desdites itérations de décodage, chacune desdites étapes successives de décodage desdits bits reçus est précédée d'une étape de démodulation correspondante.

Les bits reçus sont donc tout d'abord démodulés, puis décodés.

De manière avantageuse, un tel procédé de réception comprend au moins deux-itérations de décodage successives, une étape de décodage des bits d'un niveau donné tenant compte, lors de la $n^{\text{ième}}$ itération, où $n \geq 2$, du résultat d'au moins certaines desdites étapes de décodage desdits bits reçus affectés aux niveaux de codage moins robustes que ledit niveau donné, et mises en oeuvre lors d'au moins une desdites itérations précédentes.

Ainsi, dans un cas particulier comprenant trois niveaux de codage, le décodage des bits du niveau le plus robuste tient compte notamment, lors de la deuxième itération, du résultat du décodage des bits des deux niveaux les moins robustes obtenu lors de la première itération.

Préférentiellement, un tel procédé de réception comprend deux itérations de décodage successives.

En effet, les inventeurs ont constaté que l'accroissement des performances résultant de la mise en oeuvre d'une troisième itération était faible, ou à tout le moins négligeable par rapport à l'augmentation de la complexité correspondante.

Avantageusement, à l'issue d'au moins certaines desdites itérations, un tel procédé de réception met en oeuvre une étape d'estimation d'un symbole émis, et une étape de calcul d'une information extrinsèque tenant compte dudit symbole émis estimé, ladite information extrinsèque permettant d'améliorer le résultat desdites étapes de décodage de la ou lesdites itérations suivantes.

Ainsi, après la première itération de décodage, on calcule une information extrinsèque qui sera utilisée lors de la deuxième itération de décodage, pour en accroître les performances.

De manière avantageuse, ladite information extrinsèque est de la forme : $\alpha(S_r-S_e)$, où $\alpha \in [0, 1]$, $S_r$ est ledit symbole reçu et $S_e$ est ledit symbole émis estimé.

Dans le cas particulier où deux itérations successives sont mises en oeuvre, l'information extrinsèque est donc proportionnelle à la différence du symbole reçu et du symbole estimé à partir des bits décodés des différents niveaux lors de la première itération. Cette différence est pondérée par un coefficient caractéristique de la confiance accordée au décodage.

Dans un premier mode de réalisation avantageux de l'invention, $\alpha$ est sensiblement égal à 0,25.

Une telle valeur de $\alpha$ permet d'obtenir des performances satisfaisantes lors de la deuxième itération de décodage, pour la plupart des canaux de transmission considérés.

Dans un deuxième mode de réalisation avantageux, un tel procédé de réception comprend une étape d'optimisation de la valeur de $\alpha$ en fonction du rapport signal à bruit.

Par l'intermédiaire du coefficient $\alpha$, on peut en effet choisir d'accorder une plus ou moins grande confiance, dans l'information extrinsèque, au symbole émis estimé, afin d'en tenir plus ou moins compte lors des itérations de décodage suivantes. L'optimisation de la valeur de $\alpha$ en fonction du rapport signal à bruit conduit à des valeurs de $\alpha$ proches de 1 lorsque le rapport signal à bruit est très bon, et à des valeurs proches de 0 dans le cas contraire.

Selon une caractéristique avantageuse de l'invention, un tel procédé de réception comprend en outre une étape de détermination d'un rapport signal à bruit à partir d'au moins une information de référence émise, appelée pilote, dont la valeur est connue a priori en réception.

On rappelle en effet que pour estimer le canal de transmission en OFDM par exemple, une technique classique consiste à insérer, dans le flux de porteuses utiles, des porteuses de référence, à des emplacements connus du récepteur. En réception, les valeurs prises par ces porteuses de référence, appelées pilotes, sont lues, et on en déduit aisément le gain complexe du canal à ces emplacements de référence. On dérive alors le gain complexe du canal sur l'ensemble des points du réseau temps-fréquence transmis, à partir de la valeur calculée du gain complexe aux emplacements de référence.

Un tel mécanisme à base de pilotes peut donc être utilisé, dans le cadre de l'invention, pour déterminer le rapport signal à bruit, et donc optimiser $\alpha$. Il est notamment utilisé par la norme DVB-T ("Digital Video Broadcasting (DVB) ; Framing Structure, Channel Coding and Modulation for Terrestrial Television (DVB-T)", "Diffusion vidéo numérique (DVB) ; structure de trame, codage de canal et modulation pour la télévision numérique terrestre (DVB-T), ETS 300 744, Mars 1997).

Selon un mode de réalisation avantageux de l'invention, un tel procédé de réception comprend en outre, pour au moins certains desdits niveaux de codage, une étape supplémentaire de désentrelacement mise en oeuvre entre lesdites étapes de démodulation et de décodage desdits bits reçus.

Un tel mode de réalisation permet notamment d'améliorer les performances du procédé de réception vis-à-vis des canaux de transmission affectés de Doppler.

L'invention concerne également un procédé de décodage d'un signal modulé selon la revendication 16.

L'invention concerne aussi un dispositif de réception d'un signal modulé selon la revendication 17.

L'invention concerne encore un système de codage/décodage d'un signal selon la revendication 18.

L'invention concerne enfin les applications du procédé de réception décrit précédemment à l'un au moins des domaines suivants :

- les transmissions radio numériques, notamment de type DRM ("Digital Radio Mondiale") ;
- les codes correcteurs d'erreurs ;
- le traitement numérique du signal ;
- les communications numériques ;
- l'enregistrement/restitution d'un signal numérique.

D'autres caractéristiques et avantages de l'invention apparaîtront plus clairement à la lecture de la description suivante d'un mode de réalisation préférentiel, donné à titre de simple exemple illustratif et non limitatif, et des dessins annexés, parmi lesquels :

- la figure 1, déjà décrite en relation avec l'art antérieur, présente un exemple de partition d'une constellation $A_0$ en $m$ niveaux, donnant $2^m$ sous-ensembles, quand $m=2$ ;
- la figure 2, déjà décrite en relation avec l'art antérieur, présente un synoptique d'un codeur multi-niveaux ;
- la figure 3, également décrite en relation avec l'art antérieur, présente un schéma synoptique du décodeur par étapes mis en oeuvre dans l'art antérieur, en association avec le codeur multi-niveaux de la figure 2, dans le cas d'un codage à trois niveaux ;
- la figure 4 présente une comparaison de la robustesse de différents niveaux de codage MLC en fonction d'un bruit blanc additif gaussien ;
- la figure 5 présente un exemple de récepteur selon l'invention, réalisant le décodage optimisé d'un symbole MAQ64 avec deux itérations et utilisation de l'information extrinsèque ;
- la figure 6 illustre les performances de décodage comparées des MLC selon le procédé de décodage sous-optimal de l'état de la technique et selon le procédé de décodage de l'invention.

Le principe général de l'invention repose sur la prise en compte de la robustesse au bruit des différents niveaux de codage d'un signal modulé selon une technique de codage multi-niveaux MLC, pour déterminer l'ordre de décodage des bits reçus.

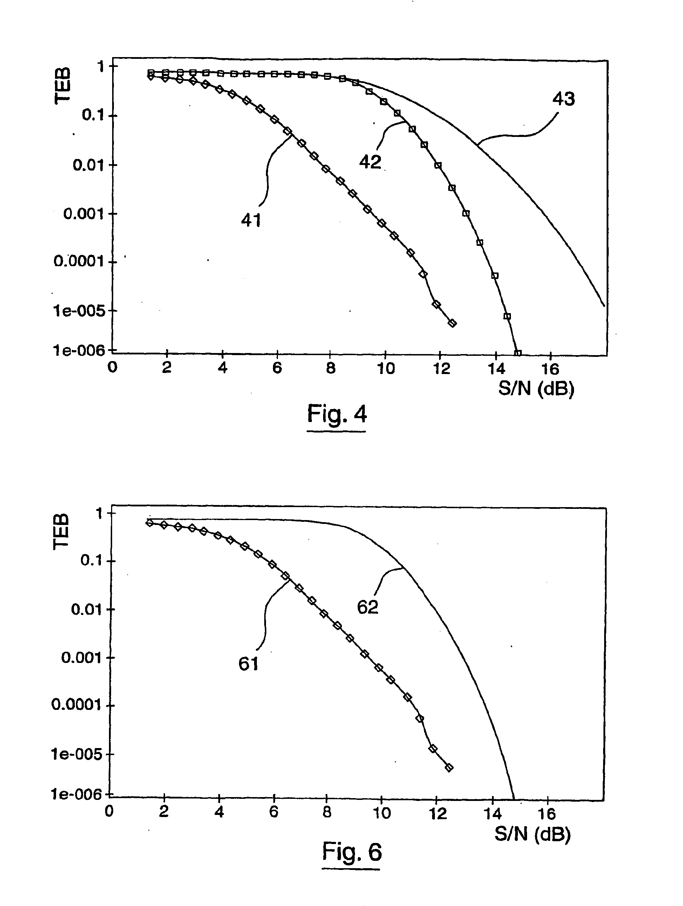

On présente, en relation avec la figure 4, le concept de robustesse d'un niveau de codage, dans le cadre d'une technique de codage multi-niveaux MLC.

La robustesse d'un niveau de codage peut être illustrée par la courbe du taux d'erreurs binaires de ce niveau, en fonction du rapport signal à bruit (S/N) : dans tout le document, on considèrera qu'un niveau de codage est d'autant plus robuste que le taux d'erreur binaire qui lui est associé est faible.

En décodant chaque niveau de codage indépendamment, c'est-à-dire sans effectuer un quelconque rebouclage d'un niveau sur l'autre (en d'autres termes, le résultat du décodage d'un niveau n'est pas utilisé lors du décodage du niveau suivant), il est possible de déterminer le niveau de robustesse de chaque niveau vis-à-vis du bruit. Plus particulièrement, la figure 4 illustre la robustesse de chaque niveau de codage MLC vis-à-vis d'un bruit blanc additif gaussien.

Ainsi, le consortium de normalisation DRM (Digital Radio Mondiale, tel que présenté dans le document ETSI ES 201 980 V1.2.1 (2002-07)) a retenu le codage multi-niveaux MLC pour la diffusion d'un signal numérique dans les bandes AM (en anglais "Amplitude Modulated" pour "modulées en amplitude"), dont les fréquences sont inférieures à 30MHz. L'un des modes retenus par DRM comprend une modulation 64QAM (en anglais "Quadrature Amplitude Modulation" pour "modulation d'amplitude en quadrature") avec un rendement de codage global de R=0,6 avec $R_{MSB}$=0,8 $R_{ISB}$=0,67 et $R_{LSB}$=0,33, où MSB représente l'ensemble des bits les plus significatifs ("Most Significant Bits" en anglais), LSB représente l'ensemble des bits les moins significatifs (en anglais "Least Significant Bits") et ISB représente l'ensemble des bits intermédiaires ("Intermediate Significant Bits").

Ainsi, un point de la constellation 64QAM correspond à un ensemble de trois bits, à savoir un bit affecté au niveau MSB, un bit du niveau ISB, et un bit du niveau LSB.

En décodant les trois niveaux de la modulation QAM, MSB, ISB et LSB, on remarque que le niveau le plus robuste est celui qui correspond aux bits MSB (courbe référencée 41), puis aux bits LSB (courbe référencée 42) et enfin au niveau intermédiaire ISB (courbe référencée 43), ainsi qu'illustré par la figure 4. En effet, la courbe de TEB 41 associée au niveau MSB est celle qui décroît le plus rapidement en fonction du rapport signal à bruit (S/N), et la courbe de TEB 43 associée au niveau ISB est celle qui décroît le plus lentement en fonction du rapport signal à bruit (S/N).

Cependant, on peut analyser à nouveau les performances des niveaux ISB et LSB, en effectuant un re-bouclage du niveau le plus robuste (MSB), c'est-à-dire en tenant compte du résultat du décodage du niveau MSB lors du décodage des niveaux ISB et LSB.

On constate alors que le niveau ISB devient le deuxième niveau le plus robuste, devant le niveau LSB : ainsi, l'ordre décroissant de robustesse des niveaux de codage est MSB-ISB-LSB.

Selon la technique proposée par l'invention, l'ordre du décodage des MLC optimal est donc l'ordre décroissant de robustesse MSB-ISB-LSB.

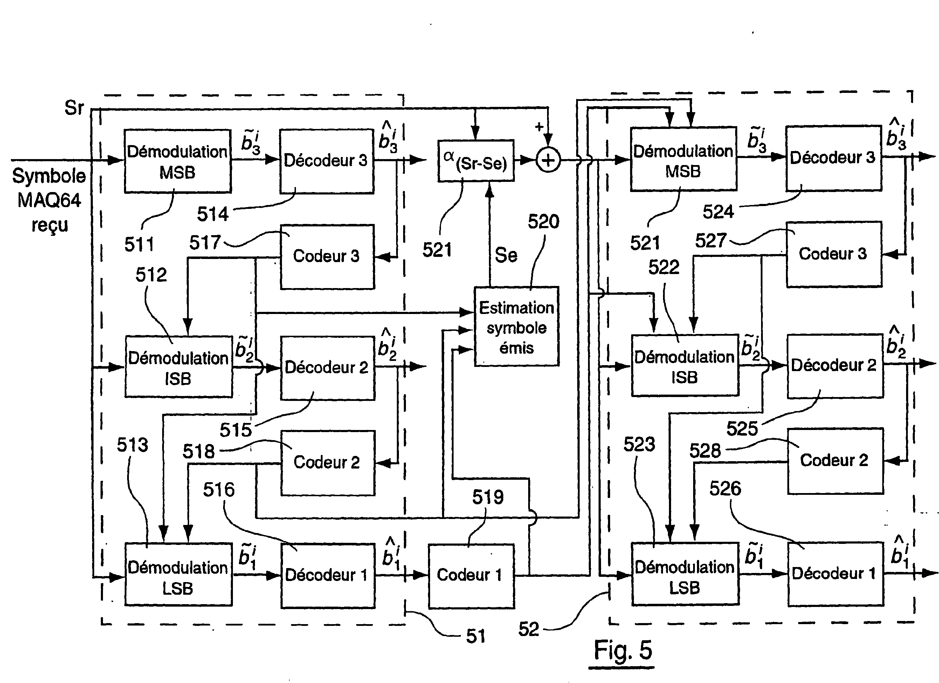

On présente désormais, en relation avec la figure 5, un exemple de réalisation d'un récepteur selon l'invention.

Le fonctionnement d'un tel récepteur repose sur quatre principes principaux :

- le premier principe repose sur la démodulation, puis le décodage, tout d'abord du niveau le plus robuste, le résultat d'un tel décodage permettant d'améliorer la démodulation, et donc le décodage, des niveaux moins robustes. Cette opération est répétée jusqu'au niveau de codage le moins robuste ;
- le second principe mis en oeuvre par un récepteur selon l'invention est celui d'un processus itératif. En effet, après démodulation et décodage de tous les niveaux, l'opération peut être répétée, de façon à améliorer la démodulation du niveau le plus robuste à l'aide du résultat du décodage des niveaux inférieurs ;
- le troisième principe de fonctionnement repose sur la mise en oeuvre d'un test de la pertinence de la correction du signal démodulé en fonction de l'amplitude du signal correctif par rapport au signal à démoduler ;
- enfin, un tel récepteur utilise une information extrinsèque, entre chaque itération, dans le but d'améliorer la démodulation et donc le décodage du signal reçu.

Ces quatre principes sont présentés plus en détail en relation avec la figure 5, qui présente un mode de réalisation particulier, dans le cadre d'une modulation MAQ64 (Modulation d'Amplitude en Quadrature). Il sera bien sûr aisé, pour l'Homme du Métier, de généraliser cette description à tout type de modulation multi-niveaux.

Dans le mode de réalisation particulier de la figure 5, le niveau le plus robuste correspond au niveau de codage des bits de poids fort (MSB pour "Most Significant Bits") et le niveau le moins robuste correspond aux bits de poids faible (LSB pour "Least Significant Bits"). Comme expliqué précédemment en relation avec la figure 4, la robustesse d'un niveau de codage vis-à-vis du bruit est inversement proportionnelle au taux d'erreur de ce niveau. En outre, le taux d'erreur est fonction du rendement du codage, de la puissance associée à chaque bit (encore appelée niveau du bit) et du rapport signal à bruit (en effet, les erreurs observées sur le signal dépendent bien sûr du bruit qui l'affecte).

On comprendra donc aisément que le niveau le plus robuste n'est pas nécessairement le niveau des bits les plus significatifs. A titre d'illustration, on s'attache cependant dans la suite de la description à présenter un mode de réalisation de l'invention dans ce cas particulier.

Le récepteur de la figure 5 comprend deux étages référencés 51 et 52, correspondant à deux itérations de décodage successives. En effet, les inventeurs ont constaté que l'amélioration des performances du décodage résultant de la mise en oeuvre d'une troisième itération de décodage était faible et, dans un mode de réalisation préférentiel de l'invention, seules deux itérations du processus de décodage sont mises en oeuvre. On obtient ainsi un bon compromis performance/complexité.

On décrit tout d'abord le premier étage de décodage référencé 51. Cet étage est alimenté par le symbole MAQ64 reçu, encore appelé $S_r$, qui est distribué vers les trois démodulateurs référencés 511 à 513, assurant respectivement les démodulations MSB, ISB et LSB. Le symbole reçu $S_r$ est formé de trois bits $X_{RMSB}$, $X_{RISB}$, $X_{RLSB}$ affectés respectivement aux niveaux MSB, ISB et LSB, ce qui peut être exprimé sous la forme : $S_r = X_{RMSB} + X_{RISB} + X_{RLSB}$.

La première étape mise en oeuvre à la réception du symbole $S_r$ consiste à démoduler les bits affectés au niveau le-plus robuste au bruit, c'est-à-dire en l'espèce les bits de poids fort (MSB). On obtient, en sortie du démodulateur 511, les bits démodulés $\tilde{b}_3^i$, $i=1,...,n$, qui alimentent le décodeur référencé 514. Après décodage par le décodeur 514, on obtient les bits décodés $\tilde{b}_3^i$, $i=1,...,n$.

La deuxième étape consiste à coder les bits décodés $\tilde{b}_3^i$, $i=1,...,n$ avec le codeur utilisé à l'émission, appelé "codeur 3", référencé 517. Les bits ainsi codés alimentent le démodulateur ISB référencé 512, qui en tient compte pour démoduler les bits de poids intermédiaires (ISB) $\tilde{b}_2^i$, $i=1,...,n$. Les bits de poids intermédiaires démodulés sont fournis en entrée du décodeur référencé 515, qui délivre, après décodage, les bits de poids intermédiaire décodés $\tilde{b}_2^i$, $i=1,...n$, On notera que le niveau de codage ISB est ici le niveau de robustesse au bruit intermédiaire, et qu'il est donc démodulé et décodé directement après le niveau MSB.

Les bits de poids intermédiaire décodés $\tilde{b}_2^i$, $i=1,...,n$ sont en outre fournis en entrée du codeur référencé 518, qui est identique au codeur utilisé à l'émission pour le niveau ISB.

En utilisant les bits recodés des niveaux de robustesse supérieurs (MSB et ISB), on peut ensuite démoduler les bits du niveau le moins robuste, qui, dans le mode de réalisation particulier décrit en relation avec la figure 5, correspond au niveau des bits de poids faibles (LSB).

Pour ce faire, le dispositif de démodulation LSB référencé 513 est alimenté par les bits recodés issus des codeurs référencés 517 et 518 des niveaux les plus robustes MSB et ISB, et délivre les bits démodulés de poids faible $\tilde{b}_1^i$, $i=1,...,n$. Après décodage par le décodeur référencé 516, on obtient les bits de poids faible décodés $\hat{b}_1^i$, $i=1,...,n$.

Les bits de poids faible décodés $\hat{b}_1^i$ peuvent en outre alimenter le codeur référencé 519, qui est identique au codeur utilisé à l'émission pour le niveau LSB.

Après décodage des 3 niveaux de la constellation MAQ, il est possible de déterminer (520) une estimation du symbole émis, à partir des bits recodés délivrés par les trois codeurs référencés 517 à 519.

Ainsi, dans le mode de réalisation particulier décrit en relation avec la figure 5, le symbole émis $S_e$ est de la forme $S_e = 4b_{MSB} + 2b_{ISB} + b_{LSB}$, où $b_{MSB}$, $b_{ISB}$ et $b_{LSB}$ correspondent respectivement aux bits des niveaux MSB, ISB et LSB.

A partir du symbole émis estimé, on calcule la distance euclidienne entre le symbole émis $S_e$ et le symbole reçu $S_r$, en pondérant cette distance par un coefficient $\alpha$ ($0 < \alpha < 1$). On détermine ainsi une information extrinsèque $\alpha$ ($S_r$-$S_e$) 521, qui peut être utilisée dans le deuxième étage 52 du récepteur, pour améliorer le décodage des itérations suivantes.

Le deuxième étage de décodage 52 fonctionne de manière similaire au premier étage référencé 51. Il comprend notamment trois dispositifs de démodulation référencés 521 à 523, et trois décodeurs référencés 524 à 526 associés respectivement aux trois niveaux de codage MSB, ISB et LSB.

La première étape mise en oeuvre au sein de cet étage 52 est la démodulation du niveau le plus robuste MSB par le bloc référencé 521. Un tel bloc 521 est alimenté, d'une part, par les bits recodés des niveaux moins robustes ISB et LSB, issus des codeurs référencés 518 et 519 du premier étage de décodage 51, et d'autre part, par le symbole reçu $S_r$ auquel a été soustraite l'information extrinsèque $\alpha(S_r$-$S_e)$, soit $S_r (1-\alpha) + \alpha S_e$.

Le coefficient $\alpha$ est préférentiellement choisi proche de 0,25. Dans une variante de réalisation, la valeur du coefficient $\alpha$ est optimisée en fonction du rapport signal à bruit. De cette façon, en fonction du rapport signal à bruit, on peut choisir d'accorder une plus ou moins grande confiance à l'estimation 520 du symbole émis, pour en tenir plus ou moins compte lors de la deuxième itération de décodage, et notamment lors du décodage du niveau le plus robuste MSB.

Ainsi, si le rapport signal à bruit est très bon, on choisira $\alpha$ proche de 1. Dans le cas contraire, $\alpha$ sera choisi proche de 0.

Une telle optimisation de $\alpha$ peut notamment être précédée d'une étape de détermination du rapport signal à bruit, au moyen de pilotes, insérés dans le signal émis. Selon une technique connue, les pilotes constituent des informations de référence, dont la valeur est connue a priori du récepteur. En comparant cette valeur prédéterminée des pilotes à la valeur des pilotes reçus, le récepteur peut, par division, estimer la fonction de transfert du canal de transmission, et donc le rapport signal à bruit affectant le signal émis. Cette technique permet en outre d'évaluer la robustesse des différents niveaux de codage.

Après démodulation par le bloc référencé 521, on obtient de nouveaux bits démodulés $\tilde{b}_3^i$, $i=1,...,n$, améliorés par rapport aux bits correspondants issus du bloc de démodulation référencé 511, du fait de la prise en compte conjointe de l'information extrinsèque et du résultat du décodage des niveaux moins robustes LSB et ISB du premier étage de décodage 51.

Ces bits $\tilde{b}_3^i$, $i=1,...,n$ démodulés alimentent le décodeur référencé 524, qui délivre des bits décodés améliorés $b_3^i$, $i=1,...,n$. Comme précédemment, ces bits sont recodés par le codeur, identique à celui de l'émission, référencé 527, puis alimentent le dispositif de démodulation du niveau ISB référencé 522. Ce dispositif de démodulation 522 est en outre alimenté en entrée par la différence entre le symbole reçu et l'information extrinsèque, sous la forme $S_r$ (1-$\alpha$) + $\alpha S_e$, et par les bits recodés du niveau le moins robuste LSB, issus du codeur référencé 519.

Le démodulateur ISB 522 délivre des bits de poids intermédiaire démodulés $\tilde{b}_2^i$, $i=1,...,n$, qui alimentent le décodeur référencé 525 délivrant des bits décodés améliorés $\tilde{b}_2^i$, $i=1,...,n$.

A nouveau, ces bits $\tilde{b}_2^i$, $i=1,...,n$ sont recodés au moyen du codeur, identique à celui utilisé à l'émission, référencé 528, puis sont fournis en entrée du bloc de démodulation du niveau le moins robuste LSB référencé 523. Ce bloc de démodulation référencé 523 est en outre alimenté par la différence entre le symbole reçu et l'information extrinsèque, sous la forme $S_r$ (1-$\alpha$) + $\alpha S_e$. Il délivre donc des bits démodulés $\tilde{b}_1^i$, $i=1,...,n$ améliorés par rapport aux bits correspondants issus du premier étage de décodage référencé 513, qui alimentent le décodeur référencé 526, ce dernier délivrant des bits décodés améliorés $b_1^i$, $i=1,...,n$.

La mise en oeuvre de ces deux itérations de décodage successives, conjuguées à l'utilisation d'une information extrinsèque, permet d'obtenir des résultats de performance accrues par rapport aux techniques de l'art antérieur, et notamment par rapport au procédé de décodage par étapes sous-optimal classiquement mis en oeuvre pour le décodage de signaux modulés selon une technique de codage multi-niveaux.

Ces performances sont illustrées par les courbes de la figure 6, présentant respectivement les taux d'erreurs binaires obtenus, en fonction du rapport signal à bruit S/N, pour le procédé de décodage de l'invention d'une part, et pour le procédé de décodage sous-optimal de l'état de la technique d'autre part.

Ainsi, on constate que la courbe référencée 61 du taux d'erreurs binaires obtenu selon l'invention décroît beaucoup plus rapidement, en fonction du rapport S/N, que la courbe de TEB référencée 62 obtenue selon le procédé de décodage par étapes de l'art antérieur.

Dans le cadre du consortium DRM présenté précédemment, il a été établi qu'un taux d'erreurs binaires TEB de $10^{-4}$ constituait le seuil de fonctionnement du système. On notera, en regard de la figure 6, qu'un gain d'environ 2 dB est obtenu, pour ce seuil de $10^{-4}$, entre la technique de décodage de l'art antérieur et le procédé de décodage de l'invention.

On pourrait encore améliorer les performances du système de l'invention vis-à-vis des canaux de transmission affectés de Doppler notamment, en ajoutant un entrelaceur, sur chaque niveau de codage, à l'émission. Le récepteur de la figure 5 comprendrait alors des moyens de désentrelacement, qui seraient mis en oeuvre, pour chaque niveau, après la démodulation et avant le décodage.

On notera que tout type de code peut-être utilisé dans le cadre de l'invention, et notamment les turbo-codes. Notamment, on peut envisager de mettre en oeuvre un turbo-code pour chacun des niveaux de codage.

**Revendications**

1. Procédé de décodage d'un signal modulé selon une technique de codage multi-niveaux, comprenant au moins deux niveaux de codage présentant chacun une robustesse au bruit distincte,
   ledit signal comprenant une pluralité de symboles ($S_r$) comprenant chacun au moins un bit, affecté à l'un desdits niveaux de codage,
   ledit procédé comprenant au moins deux itérations de décodage successives (51, 52) comprenant chacune des étapes successives de décodage (514, 515, 516, 524, 525, 526) de chacun desdits bits reçus, l'une au moins desdites étapes de décodage tenant compte du résultat d'au moins une éventuelle étape de décodage précédente, **caractérisé en ce qu'**il comprend les étapes suivantes :

☐ détermination de la robustesse au bruit desdits niveaux de codage, la robustesse au bruit d'un niveau de codage étant inversement proportionnelle au taux d'erreur dudit niveau de codage,

☐ détermination d'un ordre de décodage en fonction de la robustesse au bruit desdits niveaux de codage,

et **en ce qu'**au cours desdites itérations de décodage, on décode lesdits bits ($\tilde{b}_3^i$, $\tilde{b}_2^i$, $\tilde{b}_1^i$) selon ledit ordre de décodage, le ou les bits affectés au niveau de codage présentant la plus grande robustesse au bruit, appelé niveau le plus robuste, étant décodé(s) en premier.

**2.** Procédé de décodage selon la revendication 1, **caractérisé en ce que** la robustesse des niveaux de codage est déterminée en décodant chaque niveau de décodage indépendamment.

**3.** Procédé de décodage selon la revendication 1, **caractérisé en ce que** la robustesse des niveaux de codage est déterminée en décodant chaque niveau de décodage indépendamment pour déterminer le niveau de codage le plus robuste, puis en décodant les autres niveaux de codage en tenant compte du niveau de codage le plus robuste.

**4.** Procédé de décodage selon l'une quelconque des revendications 1 à 3, **caractérisé en ce que** ledit ordre de décodage correspond à l'ordre décroissant de la robustesse des niveaux de codage auxquels sont affectés lesdits bits reçus.

**5.** Procédé de décodage selon l'une quelconque des revendications 1 à 4, **caractérisé en ce que** chacune desdites étapes successives de décodage tient compte du résultat de la ou lesdites étape(s) de décodage précédente(s), de façon à améliorer le résultat desdites étapes de décodage desdits bits affectés aux niveaux moins robustes.

**6.** Procédé de décodage selon l'une quelconque des revendications 1 à 5, **caractérisé en ce que** lesdits bits affectés audit niveau le plus robuste sont les bits les plus significatifs dudit symbole correspondant.

**7.** Procédé de décodage selon l'une quelconque des revendications 1 à 6, **caractérisé en ce qu'**au sein d'une desdites itérations de décodage (51, 52), chacune desdites étapes successives de décodage desdits bits reçus est précédée d'une étape de démodulation correspondante (511, 512, 513, 521, 522, 523).

**8.** Procédé de décodage selon l'une quelconque des revendications 1 à 7, **caractérisé en ce qu'**une étape de décodage des bits d'un niveau donné tient compte, lors de la n$^{ième}$ itération de décodage, où n≥2, du résultat d'au moins certaines desdites étapes de décodage desdits bits reçus affectés aux niveaux de codage moins robustes que ledit niveau donné, et mises en oeuvre lors d'au moins une desdites itérations précédentes.

**9.** Procédé de décodage selon l'une quelconque des revendications 1 à 8, **caractérisé en ce qu'**il comprend deux itérations de décodage successives (51, 52).

**10.** Procédé de décodage selon l'une quelconque des revendications 8 et 9, **caractérisé en ce qu'**à l'issue d'au moins certaines desdites itérations, il met en oeuvre une étape d'estimation (520) d'un symbole émis ($S_e$) , et une étape de calcul d'une information extrinsèque tenant compte dudit symbole émis estimé, ladite information extrinsèque permettant d'améliorer le résultat desdites étapes de décodage de la ou lesdites itérations suivantes.

**11.** Procédé de décodage selon la revendication 10, **caractérisé en ce que** ladite information extrinsèque est de la forme :
$\alpha$ ($S_r$-$S_e$), où $\alpha \in$ [0, 1], $S_r$ est ledit symbole reçu et $S_e$ est ledit symbole émis estimé.

**12.** Procédé de décodage selon la revendication 11, **caractérisé en ce que** $\alpha$ est sensiblement égal à 0,25.

**13.** Procédé de décodage selon la revendication 11, **caractérisé en ce qu'**il comprend une étape d'optimisation de la valeur de $\alpha$ en fonction du rapport signal à bruit.

**14.** Procédé de décodage selon l'une quelconque des revendications 1 à 13, **caractérisé en ce que** il comprend en outre une étape de détermination d'un rapport signal à bruit à partir d'au moins une information de référence émise, appelée pilote, dont la valeur est connue a priori en réception.

**15.** Procédé de décodage selon l'une quelconque des revendications 7 à 14, **caractérisé en ce qu'**il comprend en outre, pour au moins certains desdits niveaux de codage, une étape supplémentaire de désentrelacement mise en oeuvre entre lesdites étapes de démodulation et de décodage desdits bits reçus.

**16.** Procédé de réception d'un signal modulé selon une technique de codage multi-niveaux, comprenant au moins deux niveaux de codage présentant chacun une robustesse au bruit distincte, ledit procédé comprenant les étapes selon l'une quelconque des revendications 1 à 15

**17.** Dispositif de réception d'un signal modulé selon une technique de codage multi-niveaux, comprenant au moins deux niveaux de codage présentant chacun une robustesse au bruit distincte,
ledit signal comprenant une pluralité de symboles comprenant chacun au moins un bit, affecté à l'un desdits niveaux de codage,
ledit dispositif comprenant des moyens de décodage (514, 515, 516, 524, 525, 526) mettant en oeuvre au moins deux itérations de décodage successives (51, 52) comprenant chacune un décodage successif de chacun desdits bits reçus ($\tilde{b}_3^i$, $\tilde{b}_2^i$, $\tilde{b}_1^i$), le décodage de l'un au moins desdits bits reçus tenant compte du résultat d'au moins un éventuel décodage précédent,
**caractérisé en ce qu'**il comprend :

☐ des moyens de détermination de la robustesse au bruit desdits niveaux de codage, la robustesse au bruit d'un niveau de codage étant inversement proportionnelle au taux d'erreur dudit niveau de codage,
☐ des moyens de détermination d'un ordre de décodage en fonction de la robustesse au bruit desdits niveaux de codage,

et **en ce qu'**au cours desdites itérations de décodage, lesdits moyens de décodage décodent lesdits bits selon ledit ordre de décodage tenant compte de la robustesse desdits niveaux, le ou les bits affectés au niveau de codage présentant la plus grande robustesse au bruit, appelé niveau le plus robuste, étant décodé(s) en premier.

**18.** Système de codage/décodage d'un signal comprenant une pluralité de symboles comprenant chacun au moins un bit, comprenant au moins un dispositif de codage permettant de moduler ledit signal selon une technique de codage multi-niveaux, comprenant au moins deux niveaux de codage présentant chacun une robustesse au bruit distincte, chacun desdits bits étant affecté à l'un desdits niveaux de codage, et au moins un dispositif de décodage comprenant :

des moyens de décodage (514, 515, 516, 524, 525, 526) mettant en oeuvre au moins deux itérations de décodage successives (51, 52) comprenant chacune un décodage successif de chacun desdits bits reçus, le décodage de l'un au moins desdits bits reçus tenant compte du résultat d'au moins un éventuel décodage précédent, **caractérisé en ce que** ledit dispositif de décodage comprend également:

des moyens de détermination de la robustesse au bruit desdits niveaux de codage, la robustesse au bruit d'un niveau de codage étant inversement proportionnelle au taux d'erreur dudit niveau de codage,
des moyens de détermination d'un ordre de décodage en fonction de la robustesse au bruit desdits niveaux de codage,
et **en ce qu'**au cours desdites itérations de décodage, lesdits moyens de décodage décodant lesdits bits selon ledit ordre de décodage tenant compte de la robustesse desdits niveaux, le ou les bits affectés au niveau de codage présentant la plus grande robustesse au bruit, appelé niveau le plus robuste, étant décodé(s) en premier.

**19.** Application à l'un au moins des domaines suivants :

- les transmissions radio numériques, notamment de type DRM "Digital Radio Mondiale";
- les codes correcteurs d'erreurs ;
- le traitement numérique du signal ;
- les communications numériques ;
- l'enregistrement/restitution d'un signal numérique,

d'un procédé de réception d'un signal modulé selon une technique de codage multi-niveaux comprenant au moins deux niveaux de codage présentant chacun une robustesse au bruit distincte, ledit signal comprenant une pluralité de symboles ($S_r$) comprenant chacun au moins un bit, affecté à l'un desdits niveaux de codage, ledit procédé comprenant au moins deux itérations de décodage successives (51, 52) comprenant chacune des étapes successives de décodage de chacun desdits bits reçus, l'une au moins desdites étapes de décodage tenant compte du résultat d'au moins une éventuelle étape de décodage précédente, ledit procédé de réception étant **caractérisé**

**en ce qu'**il comprend les étapes suivantes :

☐ détermination de la robustesse au bruit desdits niveaux de codage, la robustesse au bruit d'un niveau de codage étant inversement proportionnelle au taux d'erreur dudit niveau de codage,
☐ détermination d'un ordre de décodage en fonction de la robustesse au bruit desdits niveaux de codage,

et **en ce qu'**au cours desdites itérations de décodage, on décode lesdits bits selon ledit ordre de décodage tenant compte de la robustesse desdits niveaux, le ou les bits affectés au niveau de codage présentant la plus grande robustesse au bruit, appelé niveau le plus robuste, étant décodé(s) en premier.

**Claims**

1. Method of decoding a signal modulated according to a multi-level coding technique, comprising at least two coding levels each having a distinct robustness to noise,
said signal comprising a plurality of symbols ($S_r$) each comprising at least one bit, assigned to one of said coding levels, said method comprising at least two successive decoding iterations (51, 52) each comprising successive steps (514, 515, 516, 524, 525, 526) of decoding each of said received bits, at least one of said decoding steps taking into account the result of at least one possible preceding decoding step,
**characterised in that** it comprises the following steps:

   - determining the robustness to noise of said coding levels, the robustness to noise of a coding level being inversely proportional to the error rate of said coding level,
   - determining a decoding order according to the robustness to noise of said coding levels,

   and **in that**, during said decoding iterations, said bits ($\tilde{b}_3^i$, $\tilde{b}_2^i$, $\tilde{b}_1^i$) are decoded according to said decoding order, the bit or bits assigned to the coding level having the greatest robustness to noise, referred to as the most robust level, being decoded first.

2. Decoding method according to Claim 1, **characterised in that** the robustness of the coding levels is determined by decoding each decoding level independently.

3. Decoding method according to Claim 1, **characterised in that** the robustness of the coding levels is determined by decoding each decoding level independently in order to determine the most robust coding level, then decoding the other coding levels taking into account the most robust coding level.

4. Decoding method according to any one of Claims 1 to 3, **characterised in that** said decoding order corresponds to the decreasing order of robustness of the coding levels to which said received bits are assigned.

5. Decoding method according to any one of Claims 1 to 4, **characterised in that** each of said successive decoding steps takes into account the result of said preceding decoding step or steps, so as to improve the result of said steps of decoding said bits assigned to the less robust levels.

6. Decoding method according to any one of Claims 1 to 5, **characterised in that** said bits assigned to said most robust level are the most significant bits of said corresponding symbol.

7. Decoding method according to any one of Claims 1 to 6, **characterised in that,** within one of said decoding iterations (51, 52), each of said successive steps of decoding said received bits is preceded by a corresponding demodulation step (511, 512, 513, 521, 522, 523).

8. Decoding method according to any one of Claims 1 to 7, **characterised in that** a step of decoding the bits of a given level takes into account, during the $n^{th}$ decoding iteration, where $n \geq 2$, the result of at least certain of said steps of decoding said received bits assigned to the coding levels less robust than said given level, and implemented during at least one of said preceding iterations.

9. Decoding method according to any one of Claims 1 to 8, **characterised in that** it comprises two successive decoding iterations (51, 52).

**10.** Decoding method according to either one of Claims 8 and 9, **characterised in that,** at the end of at least certain of said iterations, it implements a step (520) of estimating a sent symbol ($S_e$), and a step of calculating an extrinsic information item taking into account said estimated sent symbol, said extrinsic information item making it possible to improve the result of said decoding steps of said following iteration or iterations.

**11.** Decoding method according to Claim 10, **characterised in that** said extrinsic information item is of the form $\alpha(S_r - S_e)$, where $\alpha \in [0,1]$, $S_r$ is said received symbol and $S_e$ is said estimated sent symbol.

**12.** Decoding method according to Claim 11, **characterised in that** $\alpha$ is substantially equal to 0.25.

**13.** Decoding method according to Claim 11, **characterised in that** it comprises a step of optimising the value of $\alpha$ according to the signal-to-noise ratio.

**14.** Decoding method according to any one of Claims 1 to 13, **characterised in that** it furthermore comprises a step of determining a signal-to-noise ratio from at least one sent reference information item, referred to as a pilot, whereof the value is known a priori in reception.

**15.** Decoding method according to any one of Claims 7 to 14, **characterised in that** it furthermore comprises, for at least certain of said coding levels, an additional deinterleaving step implemented between said steps of demodulating and decoding said received bits.

**16.** Method of receiving a signal modulated according to a multi-level coding technique, comprising at least two coding levels each having a distinct robustness to noise, said method comprising the steps according to any one of Claims 1 to 15.

**17.** Device for receiving a signal modulated according to a multi-level coding technique, comprising at least two coding levels each having a distinct robustness to noise,
said signal comprising a plurality of symbols each comprising at least one bit, assigned to one of said coding levels, said device comprising decoding means (514, 515, 516, 524, 525, 526) implementing at least two successive decoding iterations (51, 52) each comprising a successive decoding of each of said received bits ($\tilde{b}_3^i$, $\tilde{b}_2^i$, $\tilde{b}_1^i$), the decoding of at least one of said received bits taking into account the result of at least one possible preceding decoding, **characterised in that** it comprises:

- means of determining the robustness to noise of said coding levels, the robustness to noise of a coding level being inversely proportional to the error rate of said coding level,
- means of determining a decoding order according to the robustness to noise of said coding levels,

and **in that**, during said decoding iterations, said decoding means decode said bits according to said decoding order taking into account the robustness of said levels, the bit or bits assigned to the coding level having the greatest robustness to noise, referred to as the most robust level, being decoded first.

**18.** System for coding/decoding a signal comprising a plurality of symbols each comprising at least one bit, comprising at least one coding device making it possible to modulate said signal according to a multi-level coding technique, comprising at least two coding levels each having a distinct robustness to noise, each of said bits being assigned to one of said coding levels,
and at least one decoding device comprising:

decoding means (514, 515, 516, 524, 525, 526) implementing at least two successive decoding iterations (51, 52) each comprising a successive decoding of each of said received bits, the decoding of at least one of said received bits taking into account the result of at least one possible preceding decoding,

**characterised in that** said decoding device also comprises:

means of determining the robustness to noise of said coding levels, the robustness to noise of a coding level being inversely proportional to the error rate of said coding level,
means of determining a decoding order according to the robustness to noise of said coding levels,
and **in that**, during said decoding iterations, said decoding means decoding said bits according to said decoding order taking into account the robustness of said levels, the bit or bits assigned to the coding level having the greatest robustness to noise, referred to as the most robust level, being decoded first.

19. Application to at least one of the following fields:

- digital radio transmissions, in particular of the DRM "Digital Radio Mondiale" type;
- error correction codes;
- digital signal processing;
- digital communications;
- recording/restoration of a digital signal,

of a method of receiving a signal modulated according to a multi-level coding technique comprising at least two coding levels each having a distinct robustness to noise, said signal comprising a plurality of symbols ($S_r$) each comprising at least one bit, assigned to one of said coding levels, said method comprising at least two successive decoding iterations (51, 52) each comprising successive steps of decoding each of said received bits, at least one of said decoding steps taking into account the result of at least one possible preceding decoding step, said receiving method being **characterised in that** it comprises the following steps:

- determining the robustness to noise of said coding levels, the robustness to noise of a coding level being inversely proportional to the error rate of said coding level,
- determining a decoding order according to the robustness to noise of said coding levels,

and **in that**, during said decoding iterations, said bits are decoded according to said decoding order taking into account the robustness of said levels, the bit or bits assigned to the coding level having the greatest robustness to noise, referred to as the most robust level, being decoded first.

## Patentansprüche

1. Verfahren zum Decodieren eines gemäß einer Multiniveau-Codiertechnik modulierten Signals, das mindestens zwei Codierniveaus aufweist, die jeweils eine getrennte Rauschbeständigkeit aufweisen, wobei das Signal mehrere Symbole ($S_r$) aufweist, die jeweils mindestens ein Bit umfassen, das einem der Codierniveaus zugewiesen ist, wobei das Verfahren mindestens zwei aufeinanderfolgende Decodier-Iterationen (51, 52) aufweist, die jeweils aufeinander folgende Decodierschritte (514, 515, 516, 524, 525, 526) jedes der empfangenen Bits aufweisen, wobei mindestens einer der Decodierschritte das Ergebnis mindestens eines eventuellen vorhergehenden Decodierschritts berücksichtigt, **dadurch gekennzeichnet, dass** es die folgenden Schritte aufweist:

   • Bestimmen der Rauschbeständigkeit der Codierniveaus, wobei die Rauschbeständigkeit eines Codierniveaus zu der Fehlerrate des Codierniveaus umgekehrt proportional ist,
   • Bestimmen einer Decodierreihenfolge in Abhängigkeit von der Rauschbeständigkeit der Codierniveaus,

   und dass während der Decodier-Iterationen die Bits ($\tilde{b}_3{}^i, \tilde{b}_2{}^i, \tilde{b}_1{}^i$) gemäß der Decodierreihenfolge decodiert werden, wobei das oder die Bits, die dem Codierniveau zugewiesen sind, das die größte Rauschbeständigkeit hat, beständigstes Niveau genannt, zuerst decodiert wird/werden.

2. Verfahren zum Decodieren nach Anspruch 1, **dadurch gekennzeichnet, dass** die Beständigkeit der Codierniveaus bestimmt wird, indem jedes Decodierniveau unabhängig decodiert wird.

3. Verfahren zum Decodieren nach Anspruch 1, **dadurch gekennzeichnet, dass** die Beständigkeit der Codierniveaus bestimmt wird, indem jedes Decodierniveau unabhängig decodiert wird, um das beständigste Codierniveau zu bestimmen, und dass dann die anderen Codierniveaus unter Berücksichtigung des beständigsten Codierniveaus decodiert werden.

4. Verfahren zum Decodieren nach einem der Ansprüche 1 bis 3, **dadurch gekennzeichnet, dass** die Decodierreihenfolge der abnehmenden Reihenfolge der Beständigkeit der verschiedenen Codierniveaus, welchen die empfangenen Bits zugewiesen sind, entspricht.

**5.** Verfahren zum Decodieren nach einem der Ansprüche 1 bis 4, **dadurch gekennzeichnet, dass** jeder der aufeinander folgenden Decodierschritte das Resultat des oder der vorhergehenden Decodierschritte derart berücksichtigt, dass das Resultat der Decodierschritte der den weniger beständigen Niveaus zugewiesenen Bits verbessert wird.

**6.** Verfahren zum Decodieren nach einem der Ansprüche 1 bis 5, **dadurch gekennzeichnet, dass** die Bits, die dem beständigsten Niveau zugewiesen sind, die höchstwertigen Bits des entsprechenden Symbols sind.

**7.** Verfahren zum Decodieren nach einem der Ansprüche 1 bis 6, **dadurch gekennzeichnet, dass** jedem der aufeinander folgenden Decodierschritte der empfangenen Bits innerhalb einer der Decodier-Iterationen (51, 52) ein entsprechender Demodulationsschritt (511, 512, 513, 521, 522, 523) vorausgeht.

**8.** Verfahren zum Decodieren nach einem der Ansprüche 1 bis 7, **dadurch gekennzeichnet, dass** ein Decodierschritt der Bits mit einem gegebenen Niveau bei der n. Decodier-Iteration, wobei $n \geq 2$, das Ergebnis mindestens bestimmter der Decodierschritte der empfangenen Bits, die den weniger beständigen Codierniveaus zugewiesen sind als das gegebene Niveau, und die bei mindestens einer der vorhergehenden Iterationen umgesetzt werden, berücksichtigt.

**9.** Verfahren zum Decodieren nach einem der Ansprüche 1 bis 8, **dadurch gekennzeichnet, dass** es zwei aufeinander folgende Decodier-Iterationen (51, 52) aufweist.

**10.** Verfahren zum Decodieren nach einem der Ansprüche 8 und 9, **dadurch gekennzeichnet, dass** es nach mindestens bestimmten der Iterationen einen Schätzungsschritt (520) eines gesendeten Symbols ($S_e$) und einen Berechnungsschritt einer extrinsischen Information, die das geschätzte gesendete Symbol berücksichtigt, umsetzt, wobei es die extrinsische Information erlaubt, die Resultate der Decodierschritte der einen oder mehreren darauf folgenden Iterationen zu verbessern.

**11.** Verfahren zum Decodieren nach Anspruch 10, **dadurch gekennzeichnet, dass** die extrinsische Information die Form $\alpha$ ($S_r$-$S_e$) hat, wobei $\alpha \in [0,1]$ ist, $S_r$ das empfangene Symbol und $S_e$ das geschätzte gesendete Symbol ist.

**12.** Verfahren zum Decodieren nach Anspruch 11, **dadurch gekennzeichnet, dass** $\alpha$ im Wesentlichen gleich 0,25 ist.

**13.** Verfahren zum Decodieren nach Anspruch 11, **dadurch gekennzeichnet, dass** es einen Optimierungsschritt des Werts von $\alpha$ in Abhängigkeit von dem Signal-Rauschverhältnis aufweist.

**14.** Verfahren zum Decodieren nach einem der Ansprüche 1 bis 13, **dadurch gekennzeichnet, dass** es ferner einen Schritt des Bestimmens eines Signal-Rauschverhältnisses ausgehend von mindestens einer gesendeten Referenzinformation, Steuerinformation genannt, deren Wert a priori beim Empfang bekannt ist, aufweist.

**15.** Verfahren zum Decodieren nach einem der Ansprüche 7 bis 14, **dadurch gekennzeichnet, dass** es ferner für mindestens bestimmte der Codierniveaus einen zusätzlichen Entschachtelungsschritt aufweist, der zwischen dem Demodulations-und Decodierschritt der empfangenen Bits umgesetzt wird.

**16.** Empfangsverfahren eines gemäß einer Multiniveau-Codiertechnik modulierten Signals, das mindestens zwei Codierniveaus aufweist, die jeweils eine getrennte Rauschbeständigkeit aufweisen, wobei das Verfahren die Schritte nach einem der Ansprüche 1 bis 15 aufweist.

**17.** Empfangsvorrichtung für ein gemäß einer Multiniveau-Codiertechnik moduliertes Signal, das mindestens zwei Codierniveaus aufweist, die jeweils eine getrennte Rauschbeständigkeit haben,
wobei das Signal mehrere Symbole aufweist, die jeweils mindestens ein Bit, das einem der Codierniveaus zugewiesen ist, aufweisen,
wobei die Vorrichtung Decodiermittel (514, 515, 516, 524, 525, 526) aufweist, die mindestens zwei aufeinander folgende Decodier-Iterationen (51, 52) umsetzen, die jeweils ein aufeinander folgendes Decodieren jedes der empfangenen Bits
($\widetilde{b}_3{}^i$, $\widetilde{b}_2{}^i$, $\widetilde{b}_1{}^i$) aufweisen, wobei das Decodieren mindestens eines der empfangenen Bits das Resultat mindestens eines eventuellen vorausgehenden Decodierens berücksichtigt,
**dadurch gekennzeichnet, dass** sie Folgendes aufweist:

• Mittel zum Bestimmen der Rauschbeständigkeit der Codierniveaus, wobei die Rauschbeständigkeit eines Codierniveaus zu der Fehlerrate des Codierniveaus umgekehrt proportional ist,

• Mittel zum Bestimmen einer Decodierreihenfolge in Abhängigkeit von der Rauschbeständigkeit der Codierniveaus,

und dass die Decodiermittel im Laufe der Decodier-Iterationen die Bits gemäß der Decodierreihenfolge, die die Beständigkeit der Niveaus berücksichtigt, decodieren, wobei das oder die Bits, die dem Codierniveau, das die größte Rauschbeständigkeit aufweist, beständigstes Niveau genannt, zugewiesen ist/, zuerst decodiert wird/werden.

**18.** Codier-/Decodiersystem eines Signals, das mehrere Symbole aufweist, die jeweils mindestens ein Bit aufweisen, das mindestens eine Codiervorrichtung aufweist, die es erlaubt, das Signal gemäß einer Multiniveau-Codiertechnik zu modulieren, die mindestens zwei Codierniveaus aufweist, die jeweils eine getrennte Rauschbeständigkeit aufweisen, wobei jedes der Bits einem der Codierniveaus zugewiesen wird,
und mindestens eine Decodiervorrichtung, die Folgendes aufweist:

Decodiermittel (514, 515, 516, 524, 525, 526), die mindestens zwei aufeinander folgende Decodier-Iterationen (51, 52) umsetzen, die jeweils ein aufeinander folgendes Decodieren jedes der empfangenen Bits aufweisen, wobei das Decodieren des mindestens einen der empfangenen Bits das Resultat mindestens eines eventuellen vorhergehenden Decodierens berücksichtigt,

**dadurch gekennzeichnet, dass** die Decodiervorrichtung ferner Folgendes aufweist:

Mittel zum Bestimmen der Rauschbeständigkeit der Codierniveaus, wobei die Rauschbeständigkeit eines Codierniveaus zu der Fehlerrate des Codierniveaus umgekehrt proportional ist,
Mittel zum Bestimmen einer Decodierreihenfolge in Abhängigkeit von der Rauschbeständigkeit der Codierniveaus,
und dass im Laufe der Decodier-Iterationen die Decodiermittel, die die Bits gemäß der Decodierreihenfolge, die die Rauschbeständigkeit der Niveaus berücksichtigt, decodieren, wobei das oder die Bits, die dem Codierniveau, das die größte Rauschbeständigkeit aufweist, beständigstes Niveau genannt, zugewiesen ist/sind, zuerst decodiert wird/werden.

**19.** Anwendung an mindestens eines der folgenden Gebiete:

- digitale Funkübertragungen, insbesondere des Typs DRM "Digital Radio Mondiale";
- Fehlerkorrekturcodes;
- digitale Verarbeitung des Signals;
- digitale Kommunikationen;
- Aufzeichnen/Wiedergabe eines digitalen Signals,

eines Empfangsverfahrens eines gemäß einer Multiniveau-Codiertechnik modulierten Signals, das mindestens zwei Codierniveaus aufweist, die jeweils eine getrennte Rauschbeständigkeit aufweisen, wobei das Signal mehrere Symbole ($S_r$) aufweist, die jeweils mindestens ein Bit aufweisen, das einem der Codierniveaus zugewiesen ist, wobei das Verfahren mindestens zwei aufeinander folgende Decodier-Iterationen (51, 52) aufweist, die jeweils aufeinander folgende Decodierschritte jedes der empfangenen Bits aufweisen, wobei mindestens einer der Decodierschritte das Resultat mindestens eines eventuellen vorhergehenden Decodierschritts berücksichtigt, wobei das Empfangsverfahren **dadurch gekennzeichnet ist, dass** es die folgenden Schritte aufweist:

- Bestimmen der Rauschbeständigkeit der Codierniveaus, wobei die Rauschbeständigkeit eines Codierniveaus zu der Fehlerrate des Codierniveaus umgekehrt proportional ist,
- Bestimmen einer Decodierreihenfolge in Abhängigkeit von der Rauschbeständigkeit der Codierniveaus,

und dass man im Laufe der Decodier-Iterationen die Bits gemäß der Decodierreihenfolge, die die Rauschbeständigkeit der Niveaus berücksichtigt, decodiert, wobei das oder die Bits, die dem Codierniveau, das die größte Rauschbeständigkeit aufweist, beständigstes Niveau genannt, zugewiesen ist/sind, zuerst decodiert wird/werden.

Fig. 1

21

22

D1 ▭ b1

D2 ▭ b2

23

Débit
$D$ →  Conversion
série -
parallèle

• • • •

Dm ▭ bm

Sélection
d'un
sous-ensemble

Symbole
→
émis

Débit $D'/m$

## Fig. 2

31

32

33

Bloc
reçu →  Décision
dans $A_0$  $\tilde{b}_1^i$  Décodeur 1  $\hat{b}_1^i$

$\tilde{b}_2^i$

34

35

Décision
dans $B_i$

Décodeur 2  $\hat{b}_2^i$

36

Décision
dans $C_i$  $\tilde{b}_3^i$  Décodeur 3  $\hat{b}_3^i$

## Fig. 3

Fig. 4

Fig. 6

Fig. 5

## RÉFÉRENCES CITÉES DANS LA DESCRIPTION

**Littérature non-brevet citée dans la description**

- Channel Coding with Multilevel/phase Signals. *IEEE Trans. IT,* Janvier 1982, vol. 28 (1), 55-67
- Error control codes for QAM signalling. *Electronics Letter,* 1984, vol. 20, 62-63
- **SAYEGH.** A class of optimum block codes in signal space. *IEEE Trans. COM,* Octobre 1986, vol. 34 (10), 1043-1045
- **WEI.** Treillis-coded Modulation with Multidimensional Constellations. *IEEE Trans. IT,* Juillet 1987, vol. 33 (4), 483-501
- **CALDERBANK ; SLOANE.** New treillis codes based on lattices and cosets. *IEEE Trans. IT,* Mars 1987, vol. 33 (2), 177-195
- **IMAI ; HIRAKAWA.** A new multilevel coding method using error-correction codes. *IEEE Trans. IT,* Mai 1977, vol. 23 (3), 371-377